## Europäisches Patentamt
## European Patent Office
## Office européen des brevets

(11) Veröffentlichungsnummer: **0 057 958**
**A2**

(12) **EUROPÄISCHE PATENTANMELDUNG**

(21) Anmeldenummer: **82200107.9**

(22) Anmeldetag: **29.01.82**

(51) Int. Cl.³: **H 01 L 31/08**

(30) Priorität: **06.02.81 DE 3104075**

(43) Veröffentlichungstag der Anmeldung:
**18.08.82 Patentblatt 82/33**

(84) Benannte Vertragsstaaten:
**DE FR GB**

(71) Anmelder: **Philips Patentverwaltung GmbH
Steindamm 94
D-2000 Hamburg 1(DE)**

(84) Benannte Vertragsstaaten:
**DE**

(71) Anmelder: **N.V. Philips' Gloeilampenfabrieken
Pieter Zeemanstraat 6
NL-5621 CT Eindhoven(NL)**

(84) Benannte Vertragsstaaten:
**FR GB**

(72) Erfinder: **Ewaldt, Helmut
Hammerstrasse 5
D-2000 Hamburg 70(DE)**

(72) Erfinder: **Sauermann, Heinz
Rotdornstieg 15
D-2083 Halstenbek(DE)**

(72) Erfinder: **Raabe, Gerhard, Dr.
Elsa Brandströmstrasse 7
D-2000 Hamburg 70(DE)**

(72) Erfinder: **Burmeister, Rainer
Herderstrasse 28
D-2000 Hamburg 76(DE)**

(74) Vertreter: **David, Günther M. et al,
Philips Patentverwaltung GmbH Steindamm 94
D-2000 Hamburg 1(DE)**

(54) **Photoempfindlicher Halbleiterwiderstand.**

(57) Photoempfindlicher Halbleiterwiderstand mit einem einkristallinen Halbleiterkörper eines Leitungstyps, der an zwei einander gegenüberliegenden Flächen sperrfrei mit einem Anodenkontakt und mit einem Kathodenkontakt versehen ist, ist so ausgebildet, daß der Kathodenkontakt eine hochdotierte Zone vom gleichen Leitungstyp wie der Halbleiterkörper ist. Der Halbleiterkörper ist dabei mit der diesen Kathodenkontakt tragenden Fläche der Photonenstrahlung aussetzbar. Die zwischen der Fläche des Kathodenkontaktes und der Fläche des Anodenkontaktes ist mindestens tausendmal größer als die Fläche der hochdotierten Oberflächenzone des Kathodenkontaktes. Ein solcher photoempfindlicher Halbleiterwiderstand ist leicht herstellbar und weist sowohl eine geringe Trägheit als auch eine gute Empfindlichkeit auf.

FIG.1

Croydon Printing Company Ltd.

PHILIPS PATENTVERWALTUNG GMBH
N.V.PHILIPS'GLOEILAMPENFABRIEKEN

0057958

PHD 81-008 EP

"Photoempfindlicher Halbleiterwiderstand"

Die Erfindung betrifft einen photoempfindlichen Halbleiterwiderstand mit einem einkristallinen Halbleiterkörper eines Leitungstyps, der mit zwei sperrfreien Anschlußkontakten versehen ist.

Ein Halbleiterwiderstand dieser Art ist z.B. aus der Druckschrift "Sensoren" der Philips GmbH, Hamburg 1980, Seiten 29-31, bekannt.

Normalerweise werden photoempfindliche Halbleiterwiderstände aus einem polykristallinen Material hergestellt, in der Regel aus CdS. Solche Widerstände sind jedoch verhältnismäßig träge.
Photoempfindliche Halbleiterwiderstände aus einem monokristallinen Halbleitermaterial, wie Silicium oder Germanium, waren dagegen bisher verhältnismäßig unempfindlich und schwierig herzustellen.

Der Erfindung liegt die Aufgabe zugrunde, einen photoempfindlichen Halbleiterwiderstand der eingangs genannten Art so auszubilden, daß er auf einfache Weise mit Hilfe der bei der Herstellung von Halbleiterbauelementen üblichen Planartechnologie so hergestellt werden kann, daß er eine geringe Trägheit und eine gute Empfindlichkeit aufweist.

Der Erfindung liegt die Erkenntnis zugrunde, daß die gewünschten elektrischen Eigenschaften erreicht werden können, wenn die Kontaktfläche des Kathodenkontaktes wesentlich kleiner als die Kontaktfläche des Anodenkontaktes ist.

Diese Aufgabe wird erfindungsgemäß dadurch gelöst, daß ein erster Kontakt (Kathodenkontakt) eine im Halbleiterkörper erzeugte, hochdotierte Oberflächenzone vom gleichen Leitungstyp wie der Halbleiterkörper kontaktiert, daß ein zweiter Kontakt (Anodenkontakt), dessen Fläche mindestens tausendmal größer ist als die Fläche der hochdotierten Oberflächenzone des Kathodenkontaktes, die dem Kathodenkontakt gegenüberliegende Fläche sperrfrei kontaktiert, und daß der Halbleiterkörper mit der den Kathodenkontakt tragenden Fläche der Photonenstrahlung aussetzbar ist.

Die mit einer solchen Ausbildung des Halbleiterwiderstandes erzielten Vorteile sind insbesondere darin zu sehen, daß er einfach und wirtschaftlich herzustellen ist und eine gute Strahlungsempfindlichkeit bei geringer Trägheit aufweist.

Weitere Ausgestaltungen der Erfindung ergeben sich aus den Unteransprüchen.

Vorzugsweise besteht der Halbleiterkörper aus Silicium; es sind jedoch auch Germanium oder eine intermetallische Verbindung verwendbar.

Der Halbleiterkörper ist vorzugsweise N-leitend und der Kathoden- und der Anodenkontakt sind durch $N^+$-dotierte Zonen gebildet.

Der spezifische Widerstand des Halbleiterkörpers sollte größer als 100 $\Omega$ cm sein; ein zweckmäßiger Wert ist 2000 $\Omega$ cm.

Um die Lichtempfindlichkeit des Halbleiterwiderstandes so groß wie möglich zu machen, sollte die Volumenlebensdauer der Minoritätsladungsträger im Halbleiterkörper größer als 100 $\mu$s sein.

Um sicherzustellen, daß möglichst die auf den Halbleiterwiderstand auffallende Photonenstrahlung optimal ausgenutzt wird, sollte die den Kathodenkontakt tragende, der Strahlung ausgesetzte Fläche so groß gegenüber der Fläche des Kathodenkontaktes sein, daß der Wert des in dem Halbleiterkörper durch die Photonenstrahlung generierten Stromes etwa 70 % des Sättigungswertes erreicht.

Ein Ausführungsbeispiel eines photoempfindlichen Halbleiterwiderstandes nach der Erfindung wird anhand der beigefügten Zeichnungen näher erläutert.

Es zeigen:

Fig. 1     einen Schnitt durch einen photoempfindlichen Halbleiterwiderstand nach der Erfindung,

Fig. 2     eine J-U-Kennlinie des Halbleiterwiderstandes nach Fig. 1 mit der Bestrahlungsstärke als Parameter,

Fig. 3     ein Diagramm, das die Abhängigkeit des in dem Halbleiterwiderstand nach Fig. 1 generierten Stromes von der Größe seiner der Strahlung ausgesetzten Fläche, mit der Ladungsträgerlebensdauer als Parameter, zeigt.

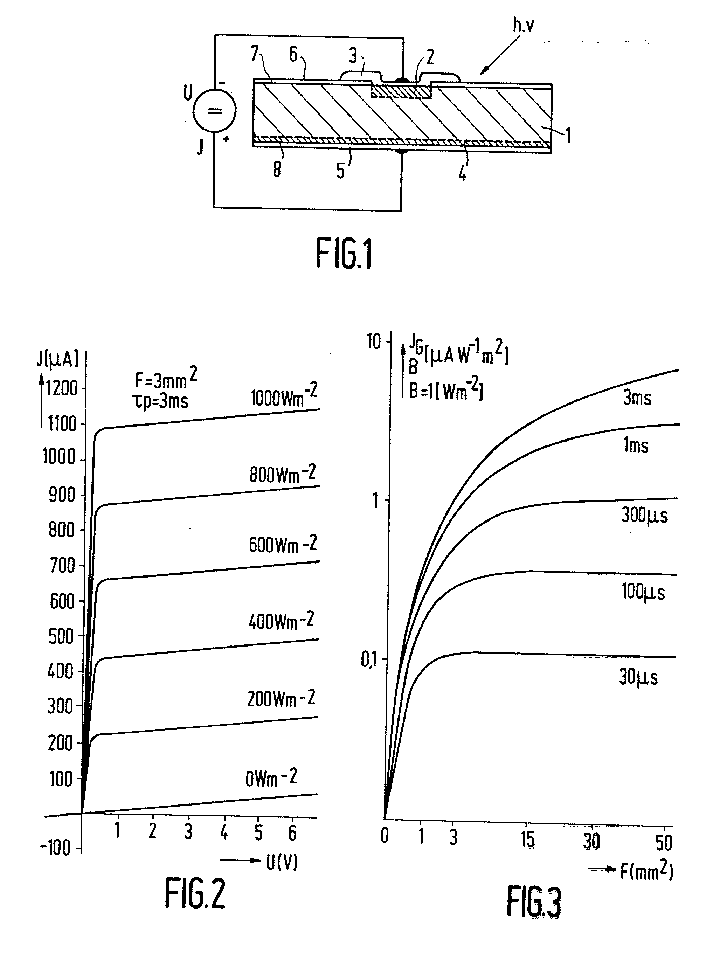

Fig. 1 zeigt einen Schnitt durch einen photoempfindlichen Halbleiterwiderstand nach der Erfindung. Die Abmessungen in Dickenrichtung sind dabei übertrieben groß dargestellt. Der Halbleiterwiderstand besteht aus einem monokristallinen Halbleiterkörper 1, vorzugsweise aus Silicium, der an seiner der Photonenstrahlung hv ausgesetzten Oberfläche 7, die mit einer strahlungsdurchlässigen Passivierungsschicht 6 bedeckt ist, einen Kathodenkontakt 2 trägt, der aus einer in den Halbleiterkörper eindiffundierten gut leitenden Zone vom gleichen Leitungstyp wie der Halbleiterkörper besteht. Die Oberfläche dieser Zone ist mit einer Anschlußmetallisierung 3 versehen, die sich bis über die Passivierungsschicht 6 erstreckt, deren Oberfläche jedoch so klein wie möglich gehalten ist, um den der Photonenstrahlung hv ausgesetzten Teil der Oberfläche 7 möglichst groß zu lassen.

Der einkristalline Halbleiterkörper 1 ist an seiner unteren Fläche 8 mit einem Anodenkontakt 4 versehen, der ebenfalls aus einer in den Halbleiterkörper eingebrachten, hochdotierten Schicht besteht. Die Oberfläche dieser Schicht ist ebenfalls mit einer Anschlußmetallisierung 5 bedeckt.

Die Flächen des Kathodenkontaktes 2 und des Anodenkontaktes 4 sind so gewählt, daß die Fläche des Anodenkontaktes 4 mindestens 1000mal größer als die Fläche der hochdotierten Oberflächenzone des Kathodenkontaktes 2 ist.

Wird der in $F_{ig}$. 1 dargestellte photoempfindliche Halbleiterwiderstand bestrahlt, so werden in der Nachbarschaft des Kathodenkontaktes 2  Loch-Elektronen-Paare erzeugt und die Löcher wandern als Minoritätsladungsträger zu diesem Kathodenkontakt. Die Minoritätsladungsträger haben eine Lebensdauer in der Größenordnung von $10^{-3}$ s und die Wahrscheinlichkeit, daß sie den Kathodenkontakt 2 erreichen, ist groß, da sie infolge der in der Umgebung des Kathodenkontaktes 2 herrschenden großen Feldstärke eine große Driftgeschwindigkeit haben. Die Elektronen als Majoritätsladungsträger wandern durch den Halbleiterkörper zu dem großflächigen Anodenkontakt 4. Die elektrische Neutralität ist dabei durch die ionisierten Störstellen sichergestellt.

Weist also der photoempfindliche Halbleiterwiderstand einen kleinen Kathodenkontakt und einen großen Anodenkontakt auf, so ist die Wahrscheinlichkeit groß, daß ein durch einfallende Photonenstrahlung erzeugtes Loch-Elektronen-Paar einen zusätzlichen Ladungsträger zum Gesamtstrom liefert; der Halbleiterwiderstand verringert also bei Strahlungseinfall seinen Widerstandswert.

Würde man die Polarität umkehren, d.h. bei dem in Fig. 1 dargestellten Halbleiterwiderstand den positiven Pol der Spannungsquelle an den kleinen Kontakt 2 und den negativen Pol an den großen Kontakt 4 legen, so würden die durch Photoneneinfall erzeugten Loch-Elektronen-Paare am Ort ihrer Entstehung wieder rekombinieren, da aus dem kleinen Kontakt 2 keine Löcher nachströmen können; er ist hoch N-dotiert, liefert daher keine Löcher und eine Trennung der Loch-Elektronen-Paare würde zu nicht erlaubten Raumladungen führen.

Bei einer solchen Polung ist also ein Einfluß einfallender Photonenstrahlung auf den Widerstandswert des Halbleiterwiderstandes kaum feststellbar.

Bei P-leitendem Halbleiterkörper (mit $P^+$-Kontakten) ist die Polarität der Spannung U entsprechend umzukehren.
Bei einem photoempfindlichen Halbleiterwiderstand der hier beschriebenen Art ist        das Verhältnis zwischen seinem Dunkelwiderstand und seinem Hellwiderstand direkt proportional

- zum spez. Widerstand des Halbleiterkörpers 1
- zur Lebensdauer $\tau_p$ der Minoritätsladungsträger im Halbleiterkörper 1
- zur Bestrahlungsstärke B

und umgekehrt proportional

- zur angelegten Spannung U
- zur Fläche des Kathodenkontaktes 2 .

Bei einem praktischen Ausführungsbeispiel besteht der Halbleiterkörper 1 aus N-leitendem Silicium mit einem spezifischen Widerstand von etwa 2000 $\Omega$cm. Die Volumenlebensdauer der Minoritätsladungsträger im Halbleiterkörper ist dabei größer als 100 µs. Der Anoden- und der Kathodenkontakt werden durch $N^+$-dotierte Zonen gebildet. Der Halbleiterkörper 1 hat eine Fläche F von etwa 3 mm$^2$ (1700 µm x 1700 µm) und eine Dicke

von 250 /um. Der Kathodenkontakt 2 hat einen Durchmesser von 20 /um und damit eine Fläche von etwa $3.10^{-4} mm^2$.

Wird an einem solchen photoempfindlichen Halbleiterkörper eine Spannung U angelegt und er einer Photonenstrahlung hv der Bestrahlungsstärke B ausgesetzt, so ergeben sich die in Fig. 2 dargestellten J-U-Kennlinien mit der Bestrahlungsstärke B als Parameter.

Der Halbleiterwiderstand hat also einen Dunkelwiderstand von etwa 100 K$\Omega$ und einen Hellwiderstand (bei einer Bestrahlungs-stärke von 1000 $Wm^{-2}$ und einer angelegten Spannung von 1 V) von etwa 1000 Ohm.

Die Fig. 3 zeigt die Abhängigkeit des in dem Halbleiterwiderstand nach Fig. 1 erzeugten Stromes $J_G$ von der Größe der der Strahlung ausgesetzten Fläche. Im praktischen Betrieb addiert sich zu diesem Strom $J_G$ noch der Dunkelstrom zum Gesamtstrom J. Der Strom $J_G$ ist in Fig. 3 auf eine Bestrahlungsstärke von 1$Wm^{-2}$ normiert. Parameter ist die Lebensdauer $\mathcal{T}_p$ der Minoritätsladungsträger im Halbleiterkörper 1.

Die Wellenlänge der einfallenden Photonenstrahlung beträgt, ebenso wie bei den Werten nach Fig. 2 , 0,6 /um.

Das Diagramm zeigt, daß der erzeugte Strom - und damit auch der Hellstrom - mit der Ladungsträgerlebensdauer und der der Strahlung ausgesetzten Fläche steigt. Dabei zeigt sich, daß - bei gegebener Fläche des Kathodenkontaktes 2 -schon bald ein Sättigungswert für den Strom $J_G$ erreicht wird. Es ist daher zweckmäßig, die der Strahlung ausgesetzte Fläche F nur so groß zu machen, daß der Sättigungswert annähernd (z.B. zu 70 %) erreicht wird.

Ein photoempfindlicher Halbleiterwiderstand nach Fig.1 kann wie folgt hergestellt werden.

0057958

Es wird ausgegangen von einer einkristallinen Siliciumscheibe, die in 111-Richtung orientiert ist und die einen spezifischen Widerstand von 2000 $\Omega$ cm und eine Volumenlebensdauer der Minoritätsladungsträger größer als 100 $\mu$s aufweist. Die Halbleiterscheibe mit einer Dicke von 250 $\mu$m wird einseitig poliert und dann mit einem thermischen Oxid von 0,8 $\mu$m Dicke bedeckt. Mit Hilfe eines Photomaskierungsschrittes wird in der thermischen Oxidschicht auf der Oberseite der Halbleiterschicht für jeden Halbleiterwiderstand ein Loch von etwa 20 $\mu$m Durchmesser eingebracht. Durch den dazu erforderlichen Ätzschritt wird auch die Rückseite der Scheibe von dem dort aufgewachsenen thermischen Oxid befreit.

In einem anschließenden Diffusionsschritt werden durch die Löcher in der Oxidschicht und gleichzeitig an der gesamten Rückseite durch Eindiffusion von Phosphor mit einer Oberflächen-Konzentration von etwa 0,9 x 10$^{21}$ über 30 min bei 1000°C N$^+$-leitende Zonen von etwa 1,5 $\mu$m Tiefe erzeugt. Dieser Diffusionsschritt hat gleichzeitig eine Getterwirkung und verbessert die Volumenlebensdauer der Minoritätsladungsträger im Halbleiterkörper.

Anschließend werden die Oberflächen der eindiffundierten N$^+$-Zonen in den Löchern der Oxidschicht auf der Oberseite der Scheibe durch Entfernen des während der Diffusion gebildeten Phosphorglases freigelegt und durch Aufdampfen von Anschlußmetallisierungen aus Aluminium von etwa 80 $\mu$m Durchmesser kontaktiert. Auf die Rückseite der Halbleiterscheibe wird ebenfalls eine Anschlußmetallisierung aus Gold-Arsen aufgedampft und einlegiert.

Die Scheibe wird dann in einzelne, die eigentlichen Halbleiterwiderstände bildende Chips von etwa 1700 $\mu$m x 1700 $\mu$m geteilt, die dann in einem geeigneten, Photonenstrahlung durchlassenden Gehäuse montiert und kontaktiert werden, wobei das Gehäuse so ausgebildet ist, daß die den Kathodenkontakt 2 tragende Oberfläche des Widerstandskörpers einer Photonenstrahlung ausgesetzt werden kann.

PATENTANSPRÜCHE:

1.        Photoempfindlicher Halbleiterwiderstand mit einem einkristallinen Halbleiterkörper (1) eines Leitungstyps, der mit zwei sperrfreien Anschlußkontakten versehen ist, dadurch gekennzeichnet, daß ein erster Kontakt (Kathodenkontakt) eine im Halbleiterkörper erzeugte, hochdotierte Oberflächenzone (2) vom gleien Leitungstyp wie der Halbleiterkörper kontaktiert, daß ein zweiter Kontakt (4) (Anodenkontakt), dessen Fläche mindestens tausendmal größer ist als die Fläche der hochdotierten Oberflächenzone des Kathodenkontaktes, die dem Kathodenkontakt gegenüberliegende Fläche sperrfrei kontaktiert, und daß der Halbleiterkörper (1) mit der den Kathodenkontakt (2) tragenden Fläche (7) der Photonenstrahlung aussetzbar ist.

2.        Halbleiterwiderstand nach Anspruch 1, dadurch gekennzeichnet, daß der Halbleiterkörper (1) aus Silicium besteht.

3.        Halbleiterwiderstand nach Anspruch 1, dadurch gekennzeichnet, daß der Halbleiterkörper aus Germanium besteht.

4.        Halbleiterwiderstand nach Anspruch 1, dadurch gekennzeichnet, daß der Halbleiterkörper aus einer intermetallischen Verbindung besteht.

5.        Halbleiterwiderstand nach einem der Ansprüche 1 bis 4, dadurch gekennzeichnet, daß der Halbleiterkörper (1) N-leitend ist und daß der Kathoden- (2) und der Anodenkontakt (4) durch $N^+$-dotierte Zonen des Halbleiterkörpers gebildet sind.

0057958

6.   Halbleiterwiderstand nach Anspruch 5, <u>dadurch gekennzeichnet</u>, daß der Kathoden- (2) und der Anodenkontakt (4) mit einer Anschlußmetallisierung (3 bzw. 5) versehen sind.

7.   Halbleiterwiderstand nach Anspruch 1, <u>dadurch gekennzeichnet</u>, daß der spezifische Widerstand des Halbleiterkörpers (1) größer als 100 $\Omega$ cm ist.

8.   Halbleiterwiderstand nach Anspruch 7, <u>dadurch gekennzeichnet</u>, daß der spezifische Widerstand des Halbleiterkörpers (1) etwa 2000 $\Omega$ cm beträgt.

9.   Halbleiterwiderstand nach Anspruch 1, <u>dadurch gekennzeichnet</u>, daß die Volumenlebensdauer der Minoritätsladungsträger im Halbleiterkörper (1) größer als 100 $\mu$s ist.

10.   Halbleiterwiderstand nach Anspruch 1 oder 6, <u>dadurch gekennzeichnet</u>, daß der der Photonenstrahlung ausgesetzte Teil der den Kathodenkontakt (2) tragenden, der Strahlung ausgesetzten Fläche (7) so groß gegenüber der Fläche des Kathodenkontaktes (2) ist, daß der Wert des in dem Halbleiterkörper durch die Photonenstrahlung generierten Stromes etwa 70 % des Sättigungswertes erreicht.

FIG.1

FIG.2

FIG.3

PHD 81-008